# DEMANDE DE BREVET EUROPEEN

(11) **EP 0 527 068 A1**
(43) Date de publication de la demande: **10.02.1993**
(21) Numéro de dépôt: 92401843.5
(22) Date de dépôt: 29.06.1992
(51) Int. Cl.: G01K 1/14, G01K 13/08, F27D 21/00, F27D 3/02, C21D 9/56, H01L 35/00

(54) **Rouleau de support ou d'entraînement de produits plats notamment pour installation de traitemant en continu**

(30) Priorité: 10.07.1991 FR 9108699
(71) Demandeur: SOLLAC, F-92800 Puteaux (FR)
(72) Inventeur: Burlion, Robert, F-57100 Thionville (FR); Deutsch, Christian, F-57000 Metz (FR); Schmit, Jean-Paul, F-57300 Hagondange (FR)
(74) Mandataire: Polus, Camille

(57) **Abrégé**

Ce rouleau de support ou d'entraînement de produits plats ou de tôle est muni d'au moins un thermocouple pour la mesure de la température de la tôle.

Le rouleau comprend un corps cylindrique creux dont la surface externe coopère par contact avec la tôle. Le thermocouple est enfilé en étant amovible dans un tube de guidage (28) qui s'étend à l'intérieur du rouleau en étant porté par des supports (42). L'extrémité du tube de guidage (28) par où débouche la soudure chaude du thermocouple est fixée perpendiculairement à la paroi du corps cylindrique (12). Cette extrémité du tube de guidage débouche dans un trou borgne (38), ménagé dans la paroi du corps cylindrique (12), où est reçue la soudure chaude du thermocouple.

Application à la mesure de la température de la tôle dans un four de recuit d'un processus de traitement en continu.

## Description

La présente invention concerne un rouleau de support et/ou d'entraînement de produits plats ou de tôle, notamment pour installation de traitement en continu.

Au cours de la fabrication de la tôle, celle-ci est traitée thermiquement dans un four de recuit en continu après les opérations de laminage. Le four, d'une longueur pouvant atteindre, voire dépasser, 130 m, assure le chauffage approprié de la tôle qui le traverse. Celle-ci est entraînée à l'intérieur du four par des rouleaux creux. En fin ou en cours de chauffage, un peu avant la sortie du four, on prévoit dans ce dernier un dispositif de mesure de la température de la tôle pour contrôler le chauffage du four.

Il est connu de relever la température de la tôle au moyen d'un thermocouple disposé dans un rouleau d'entraînement creux placé à l'intérieur du four. Pour cela, il est connu de loger la soudure chaude du thermocouple dans un trou borgne d'un bloc de matière identique à celle du rouleau et de fixer ce bloc, à force ou par soudage, dans une ouverture ménagée à travers la paroi du rouleau en un endroit où sa surface externe coopère par contact avec la tôle. De cette manière, la soudure chaude du thermocouple est fixée dans un bloc encastré dans la paroi du rouleau en étant disposée au voisinage de la surface externe du rouleau. La partie restante du thermocouple, comprenant les fils de celui-ci, s'étend à l'intérieur du rouleau.

La faible épaisseur de matière séparant la soudure chaude du thermocouple et la tôle permet d'assimiler la température relevée par le thermocouple à celle de la tôle.

Cependant, une fois que le rouleau est assemblé et qu'il est mis en place dans le four, il est impossible à un opérateur d'accéder à l'intérieur du rouleau. Par conséquent, en cas de défaillance du thermocouple, celui-ci étant fixé à l'intérieur du rouleau, on ne peut pas le remplacer sans démontage du rouleau.

Par ailleurs, la découpe réalisée dans la paroi du rouleau et la fixation du bloc de matière contenant la soudure chaude du thermocouple dans l'ouverture ainsi réalisée, créent dans cette paroi des contraintes qui peuvent provoquer la formation de fissures et de défauts sur la surface externe du rouleau.

L'invention a pour but de déterminer de façon précise la température de la tôle fabriquée au cours d'un processus de traitement en continu au moyen d'un thermocouple disposé à l'intérieur d'un rouleau d'entraînement de la tôle, le thermocouple pouvant être déplacé et remplacé sans démontage du rouleau.

A cet effet, l'invention a pour objet un rouleau du type comprenant un corps cylindrique creux, dont la surface externe coopère par contact avec la tôle, et au moins un thermocouple, disposé à l'intérieur du corps cylindrique, dont une extrémité ou soudure chaude est logée dans la paroi du corps cylindrique, au voisinage de sa surface externe, caractérisé en ce que le thermocouple est enfilé en étant amovible dans un tube de guidage qui s'étend à l'intérieur du corps cylindrique creux et dont une extrémité débouche dans un trou borgne de la paroi du corps cylindrique formant logement pour la soudure chaude.

Suivant d'autres caractéristiques de l'invention:
- l'extrémité du tube de guidage par où débouche la soudure chaude est fixée sur la surface interne du corps cylindrique au moyen d'un organe de liaison dont une première extrémité ou embase est soudée sur la surface interne du corps cylindrique et une seconde extrémité ou collier est soudée sur le tube de guidage;
- les caractéristiques de dilatation du matériau de l'organe de liaison sont sensiblement équivalentes à celles du matériau du cylindrique ;
- l'extrémité du tube de guidage par où débouche la soudure chaude et le trou borgne formant logement pour la soudure chaude sont sensiblement perpendiculaires à la paroi du corps cylindrique creux ;
- le tube de guidage est monté avec jeu, à l'intérieur du rouleau, dans des supports et cavaliers solidaires du rouleau ;
- le thermocouple est relié à des moyens de conversion du signal délivré par celui-ci, solidaires du rouleau ;
- les moyens de conversion sont constitués, pour chaque thermocouple, par un convertisseur transformant le signal en tension fourni par le thermocouple en un courant contraint ;
- un connecteur est interposé entre le thermocouple et les moyens de conversion du signal ;
- le signal de sortie délivré par les moyens de conversion est transmis à un circuit électrique fixe par rapport au rouleau par des moyens à bagues et collecteurs;
- le signal délivré par les moyens de conversion est transmis à un appareil enregistreur incorporé au rouleau, dont les données sont lues pendant des arrêts du rouleau ;
- le rouleau comporte des moyens de refroidissement à air des moyens de conversion ;
- les moyens de conversion sont disposés à l'intérieur d'un boîtier et lesdits moyens de refroidissement comprennent un orifice d'arrivée d'air de refroidissement ménagé à travers la paroi du boîtier et des supports et châssis annulaires, au voisinage de l'axe desquels sont fixés les moyens de conversion, qui délimitent un trajet de circulation de l'air dans le boîtier ;
- des moyens d'étanchéité isolent les gaz contenus dans le corps cylindrique creux des moyens de conversion.

L'invention a également pour objet un four de recuit pour le traitement en continu de produits plats ou de tôle utilisant au moins un rouleau selon l'invention.

Un exemple de réalisation de l'invention va être décrit ci-dessous en se référant aux dessins annexés dans lesquels :
- la figure 1 est une vue partielle schématique en coupe longitudinale d'un rouleau suivant l'invention;
- la figure 2 est une vue de détail en coupe de l'ensemble de la figure 1 entouré en traits mixtes et désigné par 2 ;
- la figure 3 est une vue de détail de la figure 1 montrant un premier support du tube de guidage;
- la figure 4 est une vue en coupe selon la ligne 4-4 de la figure 3 ;
- la figure 5 est une vue de détail de la figure 1 montrant un deuxième support du tube de guidage ;
- la figure 6 est une vue en coupe selon la ligne 6-6 de la figure 5 ;
- la figure 7 est une vue en coupe transversale du tube de guidage disposé dans un cavalier ;
- la figure 8 est une vue en coupe transversale du tube de guidage disposé dans un support et un cavalier;
- la figure 9 est une vue en coupe longitudinale partielle d'un dispositif électromécanique disposé à une extrémité du rouleau selon l'invention.

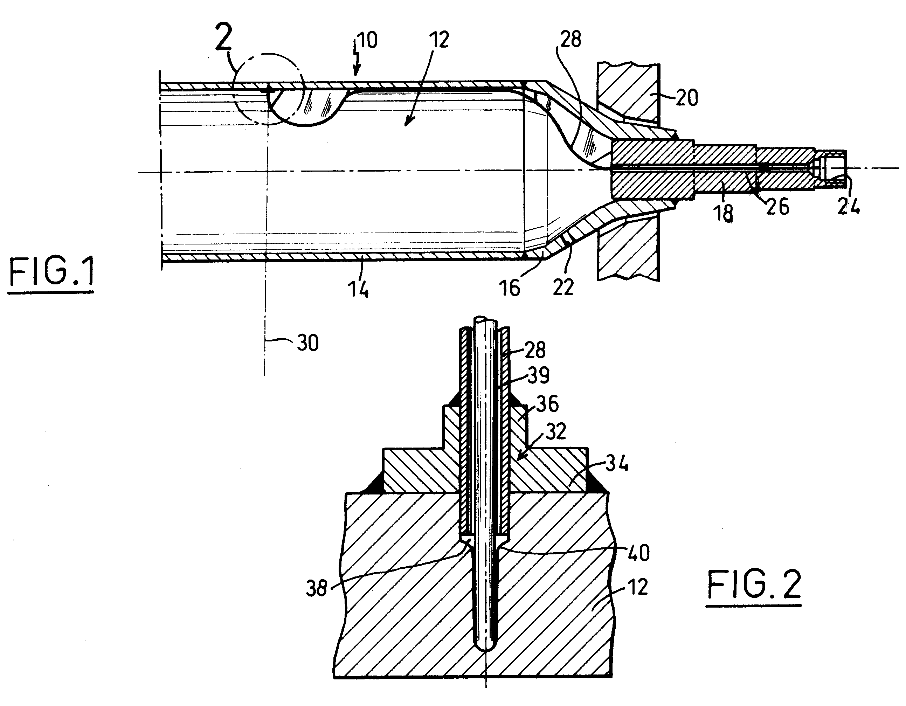

On voit à la figure 1 un rouleau d'entraînement de tôle 10 selon l'invention utilisé dans un four de recuit d'une installation de traitement en continu. Ce rouleau 10 comporte un corps cylindrique creux 12 comprenant un cylindre droit 14 fermé à ses deux extrémités respectivement par deux bouchons 16 formant un col. Pour des raisons de symétrie on a représenté un seul des bouchons 16, placé à droite du cylindre 14 en considérant la figure 1. Le cylindre 14 a, dans cet exemple, une longueur de 1800 mm, un diamètre de 600 mm et une paroi de 20 mm d'épaisseur. La surface externe de sa paroi coopère par contact avec la tôle. Les bouchons 16 sont respectivement soudés sur chaque extrémité du cylindre 14, au niveau de leur diamètre le plus grand, et comportent un arbre 18 emmanché et soudé, au niveau de leur diamètre le plus petit. Les bouchons 16 traversent une paroi 20 délimitant l'enceinte du four. Les paliers portant les arbres 18 et les organes de commande et d'entraînement du rouleau sont disposés à l'extérieur du four et ne sont pas représentés sur les figures. Des orifices 22 ménagés à peu près perpendiculairement aux parois de chaque bouchon 16 font communiquer l'intérieur du cylindre creux 12 avec l'atmosphère du four pour homogénéiser les gaz chauds présents dans le rouleau 10 et dans le four.

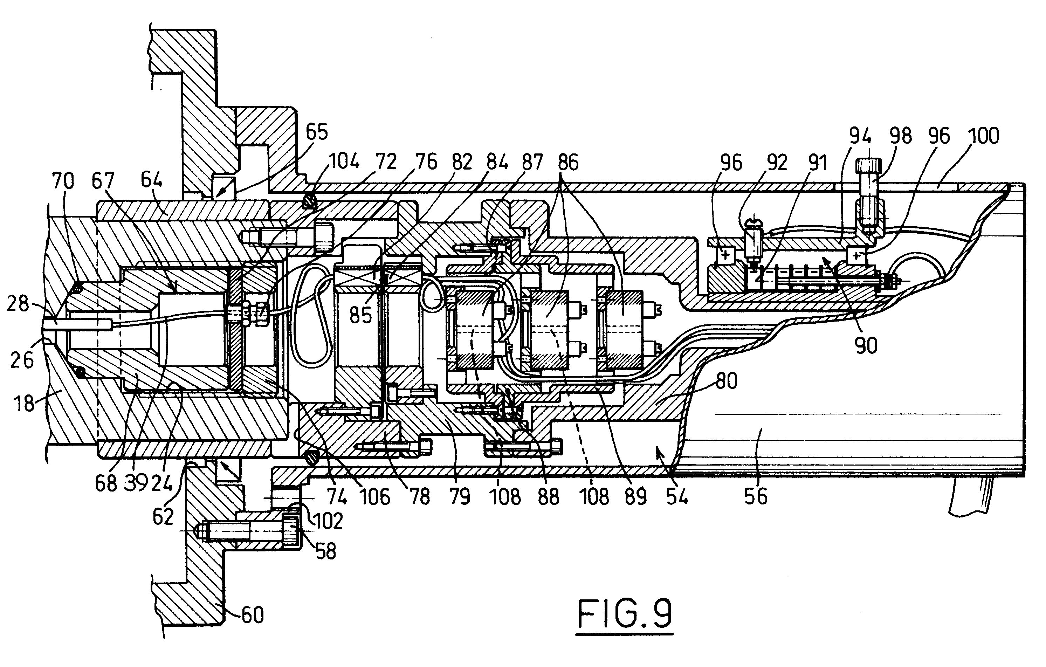

L'arbre 18 représenté à la figure 1 est étagé et délimite des portions cylindriques de diamètre décroissant en direction de l'extrémité libre de l'arbre. Cette dernière comporte un trou axial étagé 24 et un dispositif électromécanique qui est représenté à la figure 9 et qui sera décrit ultérieurement.

L'arbre 18 est traversé suivant son axe par un conduit 26 où est logé partiellement un tube de guidage 28 destiné à recevoir un thermocouple. Le tube de guidage 28 s'étend du trou étagé 24 de l'arbre 18 jusqu'à la paroi du corps cylindrique 12 où il est fixé à peu près au niveau du plan transversal médian 30 du rouleau, représenté en traits mixtes à la figure 1. Dans l'exemple décrit, le tube de guidage 28 est en acier inoxydable. Il a un diamètre de 6 mm et sa paroi a une épaisseur de 1 mm. Les moyens de positionnement du tube de guidage à l'intérieur du corps cylindrique 12 seront décrits plus en détail ultérieurement.

On voit à la figure 2 comment l'extrémité du tube de guidage 28 est fixée perpendiculairement à la paroi du corps cylindrique 12, au moyen d'un organe de liaison 32. Cet organe de liaison est de forme générale cylindrique. Il est constitué de deux portions de cylindre 34,36, l'une de grand diamètre appelée embase 34, soudée sur la surface interne du corps cylindrique 12, et l'autre de petit diamètre, appelée collier 36, soudée sur le tube de guidage 28. L'organe de liaison 32 est préférentiellement constitué d'un matériau ayant le même coefficient de dilatation que la paroi du corps cylindrique 12 afin d'optimiser la solidité de la fixation de cet organe de liaison sur la paroi du corps cylindrique 12, et d'éviter, dans celle-ci, l'apparition de contraintes qui seraient dues à des dilatations différentielles.

L'extrémité du tube de guidage 28 traverse l'organe de liaison 32 et débouche dans un trou borgne 38 ménagé dans la paroi du corps cylindrique 12, perpendiculairement à celle-ci. Dans l'exemple illustré, le fond du trou borgne 38 est à 3 mm de la surface externe du corps cylindrique 12. Cependant, on peut réduire cette distance à 1 mm en utilisant un appareil de mesure d'épaisseur précis pour l'usinage du trou borgne. En considérant la figure 2, on voit que le haut du trou borgne 38 a un diamètre intérieur adapté pour recevoir l'extrémité du tube de guidage 28, et le bas du trou borgne à un diamètre intérieur plus petit, inférieur au diamètre du tube de guidage 28, adapté pour recevoir l'extrémité d'un thermocouple 39 constituant la soudure chaude. Un épaulement 40 qui constitue la limite entre les deux parties du trou borgne 38 dont les diamètres intérieurs diffèrent a une forme arrondie afin de faciliter la mise en place de l'extrémité du thermocouple dans le fond du trou borgne 38, et d'éviter toute amorce de rupture.

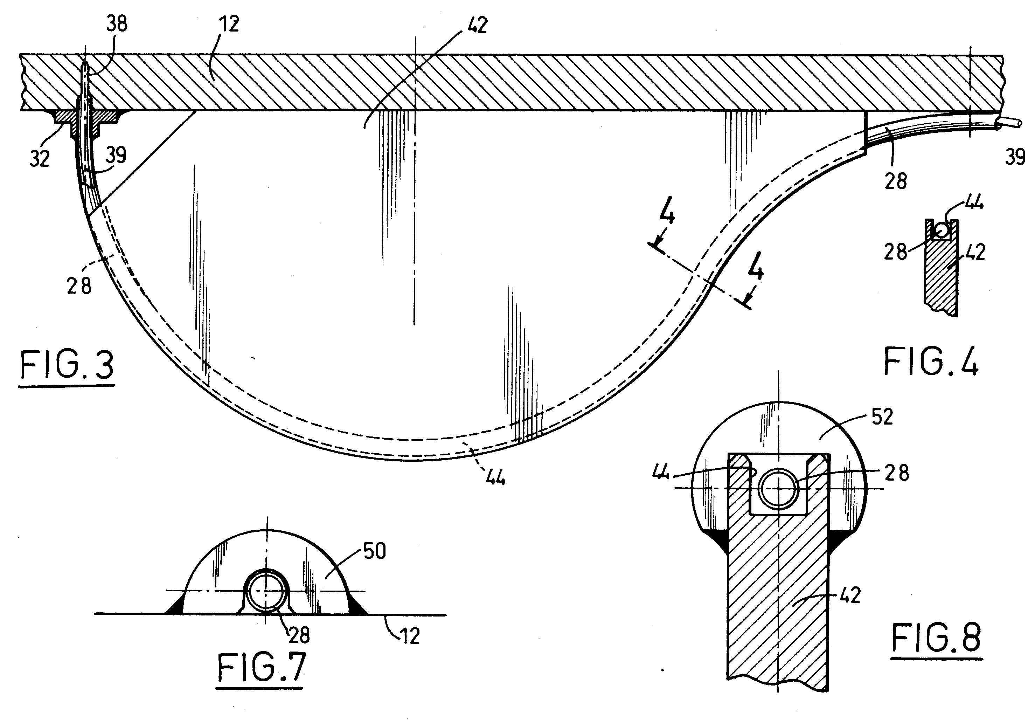

Les figures 3 à 8 montrent plus en détail le montage du tube de guidage à l'intérieur du rouleau 10. La figure 3 montre comment le tube de guidage 28 est positionné dans le corps cylindrique 12 au moyen d'un premier support 42 en forme de plaque. Ce support 42 est disposé dans un plan longitudinal du corps cylindrique creux 12, en étant fixé par un bord longitudinal sur la surface interne du corps cylindrique creux 12. Une gorge 44 est ménagée dans le bord libre ou tranche du support 42. La section de la gorge 44 est montrée à la figure 4. Les dimensions en largeur et en profondeur de la gorge 44 sont adaptées pour recevoir avec jeu le tube de guidage 28. Le contour de la tranche du support 42 où est ménagée la gorge 44 délimite des formes courbes de manière à donner au tube de guidage 28 des orientations prédéterminées. Ainsi, en considérant la figure 3, l'extrémité du tube de guidage débouche de la gorge 44, à gauche du support 42, perpendiculairement à la paroi du corps cylindrique 12. De même, le tube de guidage 28 débouche de la gorge 44, à droite du support 42, à peu près parallèlement par rapport à la paroi du corps cylindrique 12.

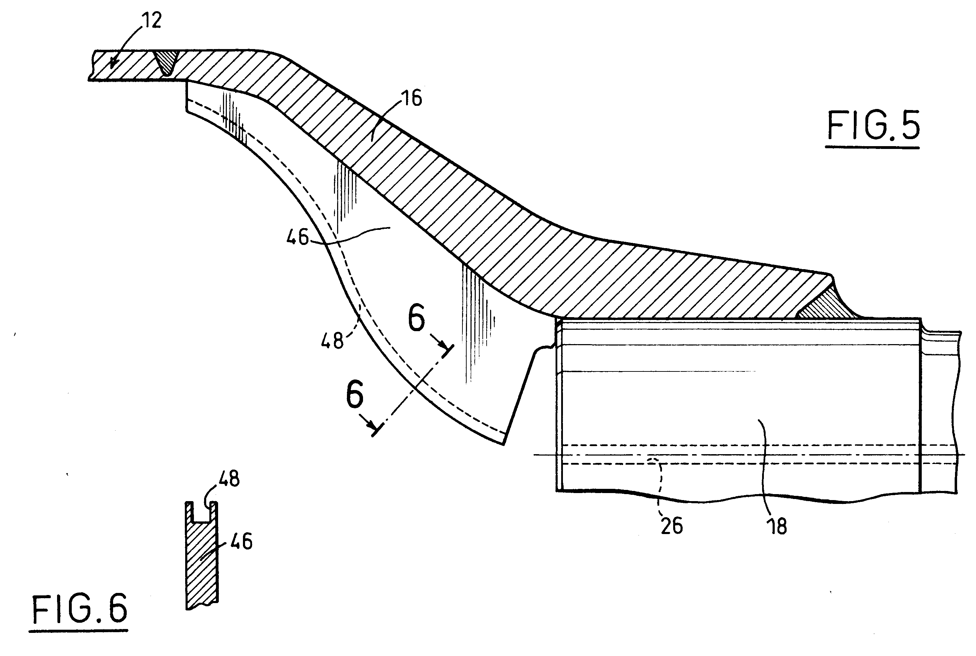

On voit à la figure 5 un second support 46 pour le tube de guidage 28, en forme de plaque, qui est disposé, comme le précédent, dans un plan longitudinal du corps cylindrique 12. Ce support 46 est fixé par un bord sur la paroi interne du bouchon 16 du corps cylindrique 12. Comme pour le support 44 décrit précédemment, une gorge 48 est ménagée dans le bord libre ou tranche du support 46. La section de la gorge 48 est montrée à la figure 6. Le contour de la tranche du support 46 délimite des formes courbes permettant de donner des orientations prédéterminées au tube de guidage 28 qui est reçu avec jeu dans la gorge 48. Ainsi, en considérant la figure 5, bien que le tube de guidage 28 ne soit pas représenté sur cette figure, on comprend qu'à gauche du support 46, le tube de guidage 28 débouche de la gorge 48 en étant à peu près parallèle à la paroi du corps cylindrique 12, et, qu'à droite du support 46, le tube de guidage 28 débouche de la gorge 48 en étant à peu près dans l'axe du conduit 26 de l'arbre 18.

Comme on a déjà pu le voir à la figure 1, le tube de guidage 28 s'étend entre les deux supports 42,46 en longeant la paroi du corps cylindrique 12. La figure 7 montre un des cavaliers 50, dits cavaliers à branches courtes, maintenant le tube de guidage 28 contre la paroi du corps cylindrique 12 entre les deux supports 42, 46. Ces cavaliers 50 sont fixés sur la surface interne de la paroi du corps cylindrique 12 par soudage. Le tube de guidage 28 est maintenu étroitement entre le cavalier 50 et la surface interne de la paroi du corps cylindrique 12.

On voit à la figure 8 un des cavaliers 52, dits cavaliers à branches longues, disposés transversalement à la gorge 44 du support 42. Des cavaliers à branches longues 52 sont également disposés sur le support 46 d'une façon analogue à celle montrée à la figure 8. On voit que, contrairement aux cavaliers à branches courtes 50 montrés à la figure 7, les cavaliers à branches longues 52 maintiennent le tube de guidage 28 avec jeu dans la gorge 44. Le tube de guidage 28 est donc maintenu avec jeu entre les parois des gorges 44,48 et les cavaliers 52 pour permettre des petits déplacements de celui-ci dus à sa dilatation.

Le thermocouple est disposé à l'intérieur du rouleau 10 en l'enfilant dans le tube de guidage 28 une fois que le rouleau est mis en place dans le four. Cependant, l'usinage du trou borgne 38 où est reçue la soudure chaude du thermocouple et la fixation du tube de guidage 28 à l'intérieur du corps cylindrique 12 doivent être réalisés avant de fixer entre eux les différents éléments constituant le rouleau 10, notamment le cylindre droit 14, les bouchons d'extrémité 16 et les arbres 18.

On a représenté sur les figures un seul tube de guidage 28 disposé dans le rouleau 10. Il va de soi que d'autres tubes de guidage 28 pour thermocouples peuvent être placés de façon analogue dans le rouleau 10. De préférence, on place dans le rouleau 10 trois thermocouples disposés respectivement dans trois tubes de guidage 28. Ceci permet d'équilibrer dynamiquement le rouleau 10 qui est entraîné en rotation. Les soudures chaudes des thermocouples sont disposées par exemple dans le plan transversal médian du rouleau 10. Mais elles peuvent être disposées également en tout point de la paroi du rouleau.

Le rouleau 10 étant mis en place dans le four, on enfile le thermocouple dans son tube de guidage 28 par l'extrémité de ce dernier qui débouche dans le trou étagé 24 de l'arbre 18. On pousse le corps du thermocouple pour placer la soudure chaude au fond du trou borgne 38 de la paroi du rouleau, à l'autre extrémité du tube de guidage 28.

On voit à la figure 9 l'extrémité de l'arbre 18 sur laquelle on a fixé un dispositif électromécanique 54 relié aux thermocouples. Le dispositif 54 est disposé à l'intérieur d'un boîtier 56 fixé par des vis 58 sur un couvercle 60 solidaire d'un palier fixe, non représenté, portant l'arbre 18. L'extrémité de cet arbre 18 traverse le couvercle 60 au niveau d'une ouverture axiale 62 de ce couvercle. Une bague d'usure 64 est emmanchée sur l'extrémité de l'arbre 18 au niveau de l'ouverture 62 du couvercle 60. Un joint à lèvre 65 assure l'étanchéité entre la bague d'usure 64 et le couvercle 60.

On a représenté à la figure 9 un seul tube de guidage 28 débouchant du conduit 26 dans le trou étagé 24 et un seul thermocouple 39 qui est logé dans le tube de guidage 28. Le thermocouple 39 est par exemple du type Chromel Alumel. Comme nous l'avons déjà précisé, on prévoit de préférence trois thermocouples et donc trois tubes de guidage 28 dans le rouleau 10. Leur montage se fait de façon analogue à ce qui a été décrit précédemment.

Comme on a déjà pu le voir à la figure 1, le conduit 26 met en communication l'intérieur du cylindre creux 12 et le trou étagé 24. Par conséquent, les gaz chauds qui sont à l'intérieur du corps cylindrique 12 peuvent atteindre le trou étagé 24 en passant par le conduit 26. Des moyens d'étanchéité 67 isolent le dispositif électromécanique 54 des gaz chauds contenus dans le four et le rouleau 10. Ces moyens d'étanchéité 67 comprennent une entretoise annulaire 68 logée dans le trou étagé 24, un joint d'étanchéité torique 70 disposé entre le fond du trou étagé 24 et une première extrémité de l'entretoise 68, et un disque d'étanchéité 72 disposé entre la seconde extrémité de l'entretoise 68 et un écrou de serrage 74 vissé dans le trou étagé 24. Le thermocouple 39 est enfilé dans un raccord ajustable 76, traversant le disque d'étanchéité 72. Le thermocouple 39 est coincé par serrage dans le raccord 76 qui le maintient ainsi enfoncé dans le tube de guidage 28.

On décrit maintenant le dispositif électromécanique 54. Celui-ci comporte un ensemble de supports annulaires 78,79,80, juxtaposés entre-eux et fixés solidairement à l'axe 18, au moyen de vis. Les supports 78,79, proches de l'arbre 18, comportent respectivement les deux éléments complémentaires 82,84 d'un connecteur miniature 85, par exemple du type fabriqué par la société Thermo Electric sous la référence CNN-21 200.KX. L'élément de connecteur 82 est relié au thermocouple 39. L'élément de connecteur 84 est relié à des moyens de conversion du signal délivré par le thermocouple, ou convertisseur 86. Le rôle du convertisseur 86 sera précisé ultérieurement. On voit sur la figure 9 que le dispositif électromécanique 54 comporte deux autres convertisseurs 86 identiques, pour deux autres thermocouples, dont on n'a pas représenté les fils électriques de raccordement ni les connecteurs correspondants. Les trois convertisseurs 86 sont respectivement disposés sur des châssis annulaires 87,88,89 fixés sur le support 79 au moyen de vis. Les convertisseurs 86 sont placés dans l'axe des châssis annulaires.

La sortie des convertisseurs 86 est raccordée à un dispositif 90 à bagues 91 et collecteurs 92 de type connu. Les bagues 91 sont fixées sur le support 80, solidaire de l'arbre 18. Les collecteurs 92, dont un seul est représenté à la figure 9, sont solidaires d'un support 94 porté par des roulements à billes 96 agencés entre ce même support 94 et le support de bagues 80. Le support de collecteurs 94 est immobilisé en rotation au moyen d'une vis 98 qui est vissée dans celui-ci et dont le corps traverse une lumière oblongue 100 du boîtier 56. Cette lumière 100 permet un déplacement de la vis d'immobilisation 98 suivant l'axe du rouleau, à la suite de la dilatation du rouleau 10.

Les convertisseurs 86 convertissent les signaux en tension (0 à 18mV) délivrés par les thermocouples, préalablement à leur transmission dans le dispositif 90 à bagues et collecteurs, en courants contraints de valeur uniquement dépendante de celles desdites tensions, et donc notamment indépendante de toutes variations de résistance (résistances de ligne ou de contact) des circuits de sortie des convertisseurs. Dans l'exemple décrit, les convertisseurs délivrent en sortie un courant compris entre 4 et 20 mA correspondant linéairement à des températures de 0 à 1000°C. De cette manière, le courant de sortie des convertisseurs est insensible aux pollutions électriques produites par les contacts entre les bagues et les collecteurs. L'ensemble bagues-collecteurs peut être de ce fait de construction courante, sans qu'il soit nécessaire de recourir à un ensemble de collecteurs sophistiqués et donc coûteux. On obtient ainsi des mesures de température précises. Par ailleurs, les sorties des convertisseurs en 4-20 mA sont normalisées et par conséquent les données fournies par les thermocouples peuvent être envoyées à un système d'acquisition et de traitement de données numériques standard, pour la régulation du four.

Grâce au connecteur 85 relié à chaque thermocouple 39, l'ensemble comprenant les convertisseurs 86 et le dispositif 90 à bagues et collecteurs est facilement démontable sans qu'il soit nécessaire de déplacer les thermocouples 39 du rouleau 10.

Il est possible de supprimer le dispositif 90 à bagues et collecteurs et de recueillir le signal délivré par les capteurs 39 sur un appareil enregistreur (non représenté sur les figures) incorporé au rouleau. Les données enregistrées sont lues sur l'appareil enregistreur lors d'arrêts du rouleau.

On décrit maintenant les moyens de refroidissement du dispositif électromécanique 54, notamment des convertisseurs 86 dont le fonctionnement requiert des températures modérées. Un orifice 102 ménagé dans le boîtier 56 au voisinage de l'extrémité de l'arbre 18 constitue une arrivée d'air de refroidissement. L'air est amené jusqu'à cet orifice d'arrivée d'air 102 par un dispositif d'alimentation de type connu, non représenté sur les figures. Dans le boîtier 56, l'air est canalisé par un joint annulaire d'étanchéité 104 disposé entre le support 78 et le boîtier 56 vers un conduit radial 106 ménagé dans le support de connecteur 78. Les formes annulaires des supports 78,79,80 et des châssis de convertisseurs 87,88,89 assurent une circulation de l'air de refroidissement suivant un trajet à peu près axial dans le boîtier 56. Le refroidissement des convertisseurs 86 est optimisé par des orifices axiaux 108 ménagés à travers ceux-ci.

Pour remplacer un thermocouple, il suffit de démonter le boîtier 56 et le dispositif électromécanique 54, puis d'extraire le thermocouple en tirant sur celui-ci au niveau du raccord 76. La mise en place d'un autre thermocouple s'effectue en enfilant celui-ci dans le raccord 76 et dans le tube de guidage 28 dont une extrémité est voisine du raccord 76.

## Revendications

1. Rouleau de support et/ou d'entraînement de produits plats ou de tôle pour traitement en continu, du type comprenant un corps cylindrique creux (12), dont la surface externe coopère par contact avec la tôle, et au moins un thermocouple (39), disposé à l'intérieur du corps cylindrique (12), dont une extrémité ou soudure chaude est logée dans la paroi du corps cylindrique (12) au voisinage de sa surface externe, caractérisé en ce que le thermocouple (39) est enfilé en étant amovible dans un tube de guidage (28) qui s'étend à l'intérieur du corps cylindrique creux (12) et dont une extrémité débouche dans un trou borgne (38) de la paroi du corps cylindrique formant logement pour la soudure chaude.

2. Rouleau selon la revendication 1, caractérisé en ce que l'extrémité du tube de guidage (28) par où débouche la soudure chaude est fixée sur la surface interne du corps cylindrique (12) au moyen d'un organe de liaison (32) dont une première extrémité ou embase (34) est soudée sur la surface interne du corps cylindrique (12) et une seconde extrémité ou collier (36) est soudée sur le tube de guidage (28).

3. Rouleau selon la revendication 2, caractérisé en ce que les caractéristiques de dilatation du matériau de l'organe de liaison (32) sont sensiblement équivalentes à celles du matériau du corps cylindrique (12).

4. Rouleau selon l'une quelconque des revendications précédentes, caractérisé en ce que l'extrémité du tube de guidage (28) par où débouche la soudure chaude et le trou borgne (38) formant logement pour la soudure chaude sont sensiblement perpendiculaires à la paroi du corps cylindrique creux (12).

5. Rouleau selon l'une quelconque des revendications précédentes, caractérisé en ce que le tube de guidage (28) est monté avec jeu, à l'intérieur du rouleau (10), dans des supports (42,46) et cavaliers (50,52) solidaires du rouleau.

6. Rouleau selon l'une quelconque des revendications précédentes, caractérisé en ce que le thermocouple (39) est relié à des moyens de conversion (86) du signal délivré par celui-ci, solidaires du rouleau.

7. Rouleau selon la revendication 6, caractérisé en ce que les moyens de conversion (86) sont constitués, pour chaque thermocouple, par un convertisseur transformant le signal en tension fourni par le thermocouple en un courant contraint.

8. Rouleau selon la revendication 6 ou 7, caractérisé en ce qu'un connecteur (85) est interposé entre le thermocouple (39) et les moyens de conversion (86) du signal.

9. Rouleau selon l'une quelconque des revendications 6 à 8, caractérisé en ce que le signal de sortie délivré par les moyens de conversion (86) est transmis à un circuit électrique, fixe par rapport au rouleau, par des moyens à bagues et collecteurs (90).

10. Rouleau selon l'une quelconque des revendications 6 à 8, caractérisé en ce que le signal délivré par les moyens de conversion (86) est transmis à un appareil enregistreur incorporé au rouleau, dont les données sont lues pendant des arrêts du rouleau.

11. Rouleau selon l'une quelconque des revendications 6 à 10, caractérisé en ce que le rouleau comporte des moyens de refroidissement à air des moyens de conversion (86).

12. Rouleau selon la revendication 11, caractérisé en ce que les moyens de conversion (86) sont disposés à l'intérieur d'un boîtier (56) et en ce que lesdits moyens de refroidissement comprennent un orifice d'arrivée d'air de refroidissement (102) ménagé à travers la paroi du boîtier (56) et des supports (78,79,80) et châssis (87,88,89) annulaires au voisinage de l'axe desquels sont fixés les moyens de conversion (86), qui délimitent un trajet de circulation de l'air dans le boîtier (56).

13. Rouleau selon l'une quelconque des revendications précédentes, caractérisé en ce que des moyens d'étanchéité (67) isolent les gaz contenus dans le corps cylindrique creux (12) des moyens de conversion (86).

14. Four de recuit pour le traitement en continu de produits plats ou de tôle, caractérisé en ce qu'il comporte au moins un rouleau selon l'une quelconque des revendications précédentes.
